# DEMANDE DE BREVET EUROPEEN

(11) **EP 3 965 177 A1**
(43) Date de publication de la demande: **09.03.2022**
(21) Numéro de dépôt: 21192810.6
(22) Date de dépôt: 24.08.2021
(51) Int. Cl.: H01L 45/00, H01L 27/24

(54) **MEMOIRE RESISTIVE A ZONE DE COMMUTATION ENTRE DEUX REGIONS DIELECTRIQUES DE DOPAGES ET/OU CONSTANTES DIELECTRIQUES DIFFERENT(E)S**

(30) Priorité: 02.09.2020 FR 2008916
(71) Demandeur: Commissariat à l'énergie atomique et aux énergies alternatives, 75015 Paris (FR)
(72) Inventeur: GRENOUILLET, Laurent, 38054 GRENOBLE CEDEX 09 (FR); BARLAS, Marios, 38054 GRENOBLE CEDEX 09 (FR); NOWAK, Etienne, 38054 GRENOBLE CEDEX 09 (FR)
(74) Mandataire: Brevalex

(57) **Abrégé**

Cellule de mémoire (C₁₁) résistive dotée d'une première électrode (10, 10₁) et d'une deuxième électrode (30₁) agencées de part et d'autre d'une couche (20) diélectrique et en regard d'une interface (23₁) entre une première région (21₁) et une deuxième région (22₁), lesdites première et deuxième région (22₁) ayant des compositions différentes en termes de dopage et/ou constante diélectrique, de sorte à confiner la zone de création réversible de filament conducteur au niveau de ladite interface.

## Description

### DOMAINE TECHNIQUE ET ART ANTERIEUR

La présente invention a trait au domaine des mémoires résistives non-volatiles et notamment à celui des mémoires résistives à base d'oxyde telles que les mémoires OxRAM (pour « Oxide resistive Random Access Memory »).

Les mémoires résistives sont basées sur la formation et la rupture réversibles de filament conducteur dans une zone appelée « zone de commutation » d'un matériau qui est normalement isolant et peut être forcé à être conducteur en formant un chemin de conduction ou un filament conducteur après l'application d'une tension suffisamment élevée. Dans le cas particulier des mémoires à base d'oxyde, le filament conducteur est réalisé à partir de lacunes d'oxygène d'un matériau isolant à base d'oxyde, typiquement un oxyde métallique tel que le HfO₂.

Une tension d'écriture est utilisée pour faire passer la zone de commutation de la couche diélectrique dans un état dit de « faible résistance », tandis qu'une tension d'effacement est utilisée pour faire passer cette zone dans un état dit de « forte résistance ».

Lorsque la cellule mémoire se trouve dans son état juste après sa fabrication, appelé « état d'origine », et n'a pas encore subi de cycle d'écriture, la zone de commutation est formée pour la première fois en appliquant à la cellule mémoire une tension dite « de formation » (« forming » selon la terminologie anglo-saxonne) supérieure à la tension d'écriture. Ensuite, la cellule mémoire entre dans un mode de fonctionnement normal dans lequel la tension d'écriture et la tension d'effacement sont utilisées pour faire basculer l'état de résistance de la cellule mémoire d'un état de forte résistance à un état de faible résistance et inversement.

Le confinement de la zone de commutation dans une localisation précise du matériau diélectrique pose problème.

Dans certains cas du fait des procédés de gravure qui sont susceptibles d'introduire des zones oxydées ou des défauts (non stoechiométrie, introduction d'espèces issues d'un plasma, ...) au niveau des bords extérieurs de la cellule des chemins conducteurs parasites sont susceptibles de se former près de ces bords.

Pour pallier ce problème, il est connu du document HAYAKAWA Y. et al. 'Highly reliable TaOx ReRAM with centralized filament for 28-nm embedded application', 2015 Symposium on VLSI Technology, Kyoto, ISSN 0743-1562, d'effectuer une oxydation latérale et de prévoir une encapsulation de la cellule mémoire avec des zones de nitrure.

Une autre solution pour améliorer le confinement de la zone de commutation est d'agir sur la tension de « forming » en adaptant la durée et l'amplitude des impulsions.

Dans le document US2010/0243983A1, une implantation des régions d'une couche d'oxyde est réalisée de manière à créer des défauts dans ces régions et essayer de favoriser la zone de commutation dans les régions implantées.

D'une manière générale, on cherche à obtenir une localisation plus précise de la zone de commutation. Il se pose également le problème de réduire la tension de formation. Il se pose également le problème de réduction des dimensions des cellules mémoires résistives.

### EXPOSÉ DE L'INVENTION

La présente invention vise à résoudre au moins l'un des problèmes mentionnés ci-dessus et prévoit selon un mode de réalisation, une structure de mémoire résistive dotée d'au moins une cellule mémoire comportant une première électrode et une deuxième électrode agencées de part et d'autre d'une couche diélectrique, la cellule mémoire étant apte à commuter de manière réversible entre un état dit « de forte résistance » et un état dit « de faible résistance », la couche diélectrique comportant une zone de commutation formant un chemin de conduction privilégié au courant lorsque la cellule mémoire se trouve dans ledit état de faible résistance, la couche diélectrique comportant une première région et une deuxième région accolées au niveau d'une interface, les première et deuxième région étant en un même matériau diélectrique avec des compositions respectives différentes en élément(s) dopant(s) ou en concentration d'élément dopant ou étant respectivement en un premier matériau diélectrique et un deuxième matériau diélectrique de constantes diélectriques respectives différentes,
la première électrode et la deuxième électrode étant agencées en regard de l'interface entre la première région et la deuxième région, l'interface s'étendant dans un plan donné traversant la couche diélectrique et passant par les électrodes de sorte à localiser la zone de commutation au niveau de la zone d'interface.

Les inventeurs ont découvert qu'avec une telle interface et un tel agencement d'électrodes par rapport à cette interface, une exacerbation du champ électrique radial au niveau de l'interface pouvait être mise en œuvre et qu'un confinement du filament conducteur au niveau de l'interface pouvait être ainsi obtenu.

Outre le fait de permettre d'obtenir un meilleur confinement de la zone de commutation, une telle cellule présente pour avantage de pouvoir fonctionner à des niveaux de tension de formation faibles.

Avantageusement, la première région s'étend, dans une direction parallèle à un plan principal de la couche diélectrique, entre l'interface et une zone située en regard d'une première face latérale d'au moins une électrode donnée parmi les première électrode et deuxième électrode, la deuxième région s'étendant, dans une direction parallèle à un plan principal de la couche diélectrique, entre l'interface et une autre zone en regard d'une deuxième face latérale de l'électrode donnée opposée à la première face latérale.

Selon une possibilité de mise en œuvre, au moins une électrode donnée parmi la première électrode et la deuxième électrode peut être centrée en regard de la zone d'interface et s'étend en regard d'une surface de la première région égale ou sensiblement égale à une surface de la deuxième région en regard de laquelle cette électrode donnée s'étend.

Selon un mode de réalisation particulier, la couche diélectrique peut comporter une alternance de régions d'un premier type ayant une composition identique à la première région et de régions d'un deuxième type et de même composition que la deuxième région, au moins une électrode donnée parmi les première électrode et deuxième électrode étant en regard d'une unique interface entre région du premier type et région du deuxième type.

Selon un mode de réalisation particulier, la structure de mémoire résistive peut comprendre en outre :
- une troisième électrode juxtaposée à, et distincte de, ladite deuxième électrode, la troisième électrode étant agencée en regard d'une autre interface entre ladite première région et une troisième région de ladite couche diélectrique,
ladite troisième région étant juxtaposée à la première région et disposée de sorte que la première région se situe entre la troisième région et la deuxième région, la première région et la troisième région étant en un même matériau diélectrique et ayant des compositions différentes en élément(s) dopant(s) ou en concentration d'élément dopant ou étant respectivement en un premier matériau diélectrique et un deuxième matériau diélectrique de constantes diélectriques respectives différentes.

La deuxième région et la troisième région peuvent être en un même matériau diélectrique.

Selon une possibilité de mise en œuvre, la mémoire peut comprendre en outre une quatrième électrode juxtaposée à la deuxième électrode et distincte de la troisième électrode, la quatrième électrode étant agencée en regard d'une autre zone d'interface entre la troisième région et une quatrième région de la couche diélectrique, la quatrième région étant juxtaposée à la troisième région, et disposée de sorte que la troisième région se situe entre la quatrième région et la deuxième région, la quatrième région étant à base du même matériau que la première région.

Avantageusement, la couche diélectrique peut être une couche d'oxyde, en particulier d'oxyde de métal de transition, la première région étant une région dopée de la couche d'oxyde à l'aide d'un premier élément dopant, en particulier du silicium ou de l'aluminium, présent selon une première concentration atomique,
- la deuxième région étant une région non-dopée de l'oxyde ou,
- ladite deuxième région étant une région dopée de l'oxyde et comportant une deuxième concentration atomique du premier élément dopant distincte de la première concentration ou,
- la deuxième région étant dopée au moyen d'un deuxième élément dopant, tel que l'aluminium ou le silicium, qui est distinct du premier élément dopant.

Un mode de réalisation particulier prévoit la première région en oxyde d'hafnium dopée au silicium ou dopée à l'aluminium, la deuxième région étant :
- en oxyde d'hafnium non dopé ou,
- en oxyde d'hafnium dopé au silicium avec une concentration en silicium inférieure à la concentration en silicium de ladite première région,
- en oxyde d'hafnium dopé au silicium lorsque la première région est en oxyde d'hafnium dopé à l'aluminium.

Selon une possibilité de mise en œuvre, la couche diélectrique est une couche d'oxyde à base de l'un des oxydes suivants : oxyde d'hafnium (HfO₂, HfOₓ), oxyde de tantale (Ta₂O₅, TaₓO_{y}), oxyde de tungstène (WOₓ), oxyde de silicium (SiO₂, SiOₓ).

Avantageusement, la première électrode s'étend dans une direction parallèle à une première direction, la deuxième électrode et la troisième électrode s'étendant dans une direction parallèle à la deuxième direction, la deuxième direction étant orthogonale à la première direction.

Selon un autre aspect, la présente demande concerne un procédé de réalisation d'une structure de mémoire telle que définie précédemment et dans lequel la couche diélectrique est une couche d'oxyde de métal de transition, le procédé comprenant des étapes de :
- implantation, à l'aide de silicium ou d'aluminium, de la couche de matériau diélectrique, de manière à réaliser la première région,
- formation sur la couche de matériau diélectrique de la deuxième électrode en regard d'une zone d'interface entre la première région et une autre zone non-dopée ou ayant un dopage différent de celui de la première région.

Selon une autre possibilité, la présente demande concerne un procédé de réalisation d'une structure de mémoire telle que définie précédemment et dans lequel la couche est une couche à base d'un premier matériau diélectrique, le procédé comprenant des étapes de :
- formation d'une ou plusieurs ouvertures dans la couche à base du premier matériau diélectrique,
- remplissage de la ou les ouvertures à l'aide d'un deuxième matériau diélectrique différent du premier matériau diélectrique.

Préalablement à la formation de la couche diélectrique, le procédé comprend également typiquement : une ou plusieurs étapes de dépôt d'une ou plusieurs première(s) couche(s) conductrice(s) pour former la première électrode.

De préférence, le procédé peut comprendre en outre, après la formation de la couche diélectrique, une ou plusieurs étapes de dépôt d'une ou plusieurs deuxième(s) couche(s) conductrice(s) pour former la deuxième électrode.

### BRÈVE DESCRIPTION DES DESSINS

La présente invention sera mieux comprise sur la base de la description qui va suivre et des dessins en annexe sur lesquels :
La figure 1 sert à illustrer un agencement particulier de cellule mémoire résistive avec une zone de commutation confinée au niveau d'une interface entre une première et une deuxième régions diélectriques de compositions différentes ;
Les figures 2A, 2B servent à illustrer une exacerbation du champ électrique radial au niveau de l'interface formée entre deux régions diélectriques de compositions différentes dans une cellule reprenant un agencement suivant l'invention ;
La figure 3 donne des exemples de gammes de tensions de formation pour différents niveaux de dopage d'une région diélectrique d'une cellule reprenant un agencement suivant l'invention ;
Les figures 4A, 4B servent à illustrer une exacerbation du champ électrique radial au niveau de l'interface formée entre deux régions diélectriques de constantes diélectriques différentes dans une cellule reprenant un agencement suivant l'invention ;
Les figures 5A, 5B, 5C servent à illustrer l'effet sur le champ électrique radial de la différence de constante diélectrique entre la première et la deuxième région diélectrique d'une cellule suivant l'invention ;
La figure 6 sert à illustrer la formation d'une région diélectrique dopée par implantation dans le cadre de la réalisation d'une cellule ayant un agencement suivant l'invention ;
Les figures 7A, 7B, 7C servent à illustrer la formation de régions diélectriques accolées à base de matériaux différents dans le cadre de la réalisation d'une cellule ayant un agencement suivant l'invention ;
La figure 8 servent à illustrer une structure de mémoire résistive suivant un mode de réalisation de la présente invention ;
La figure 9 servent à illustrer une structure de mémoire résistive suivant un autre mode de réalisation de la présente invention ;
Les figures 10A, 10B, 10C, 10D, 10E, 10F servent à illustrer un exemple de procédé de fabrication d'un dispositif mémoire suivant l'invention ;
Les figures 11, 12 servent à illustrer des configurations particulières d'électrodes ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

En outre, dans la description ci-après, des termes qui dépendent de l'orientation, tels que « vertical », « latéral », « supérieur », « inférieur », etc. d'une structure s'appliquent en considérant que la structure est orientée de la façon illustrée sur les figures.

### EXPOSÉ DÉTAILLÉ DE MODES DE RÉALISATION PARTICULIERS

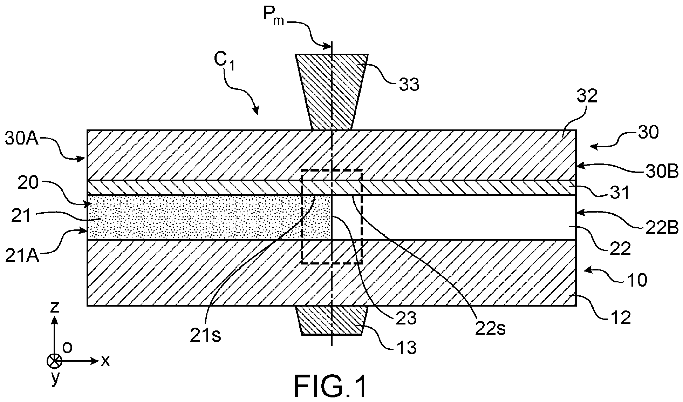

Un exemple de structure de cellule mémoire C₁ résistive suivant un mode de réalisation de la présente invention est donné sur la figure 1.

La cellule mémoire C₁ résistive et non-volatile, par exemple de type OxRAM, appartient à une matrice mémoire qui est typiquement dotée d'une pluralité de cellules (non représentées). La matrice mémoire est formée en couches minces sur un support (non représenté) tel qu'un substrat semi-conducteur ou un substrat de type semi-conducteur sur isolant.

La matrice mémoire peut être intégrée dans un étage inférieur d'un dispositif microélectronique et réalisée en particulier lors d'étapes de type dit « FEOL » pour («Front End-Of-Line »), c'est-à-dire au début d'un procédé de fabrication du dispositif microélectronique, l'étage se situant alors au niveau des transistors. En variante, la matrice mémoire peut être intégrée au-dessus d'un niveau métallique d'interconnexion ou entre des niveaux-métalliques d'interconnexion, lors d'étapes MEOL (pour « Middle-End-Of-Line») ou de type BEOL (pour « Back-End-Of-Line»).

Dans ce dernier cas, où la mémoire est située au niveau d'interconnexions métalliques, les cellules mémoires peuvent être intégrées par exemple entre un cinquième étage (« métal 5 ») de lignes de connexion et un sixième étage (« métal 6 ») de lignes de connexion ou bien entre un quatrième étage (« métal 4 ») et un cinquième étage (« métal 5 »).

La cellule mémoire C₁ résistive comporte une première électrode 10, une deuxième électrode 30 et une couche 20 de matériau diélectrique disposée entre la première électrode 10 et la deuxième électrode 30. La première électrode 10 est, dans cet exemple, appelée électrode « inférieure », tandis que la deuxième électrode 30 est nommée électrode « supérieure », les termes « inférieure » et « supérieure » étant ici utilisés pour caractériser la position des électrodes dans le référentiel des figures.

La cellule mémoire C₁ a, tout comme une cellule mémoire résistive conventionnelle, un fonctionnement lui permettant de basculer de manière réversible entre deux états de résistance en fonction de la tension appliquée à ses électrodes 10, 30.

La cellule mémoire C₁ est ainsi apte à commuter de manière réversible entre un état dit « de forte résistance » et un état dit « de faible résistance ». La couche diélectrique 20 comporte une zone dite « de commutation » dans lequel un chemin de conduction privilégié au courant appelé filament conducteur est susceptible d'être créé lorsqu'une tension appropriée est appliquée aux électrodes 10, 30. La cellule mémoire C₁ se trouve alors dans un état de faible résistance, état dans lequel un courant par exemple compris entre 5 µA et 25 µA est susceptible de la traverser.

En appliquant une tension d'effacement appropriée entre les électrodes 10, 30, on peut supprimer ou altérer au moins une partie du chemin de conduction. La cellule C₁ se retrouve alors dans un état de forte résistance avec un courant plus faible, par exemple inférieur à 10 µA, que dans l'état de faible résistance et par exemple compris entre 1 µA et 10 µA.

Le courant de lecture qui traverse la cellule lorsqu'elle est lue dépend de la tension de lecture appliquée, la tension de lecture étant, pour les valeurs de courant données précédemment, typiquement comprise entre 0.05V et 0.4V.

Les électrodes 10, 30 sont formées chacune d'une ou plusieurs couches conductrices et peuvent comporter un ou plusieurs matériaux conducteurs tels que du nitrure de titane, du titane, du tungstène. Au moins une des électrodes, dans cet exemple l'électrode supérieure 30, est dotée d'une couche 31 en matériau capteur d'oxygène (« oxygen scavenger » selon la terminologie anglo-saxonne) autrement dit ayant une forte affinité avec l'oxygène tel que par exemple du titane (Ti), du tantale (Ta), ou de l'hafnium (Hf). Cette couche 31 est ici disposée en contact de la couche 20 diélectrique. Les électrodes 10, 30 sont typiquement formées par des couches 12, 32 en matériau conducteur qui peut être également barrière de diffusion de métal vers la couche diélectrique tel que du TaN ou du TiN. Dans cet exemple, des contacts conducteurs 13, 33 en métal, par exemple tel que du tungstène, sont également prévus.

La couche de matériau diélectrique 20 peut être une couche à base d'oxyde ou contenant des régions d'oxyde, de préférence un oxyde de métal de transition par exemple tel qu'un oxyde d'hafnium HfO₂ ou HfOx, ou un oxyde de tantale Ta₂O₅ ou TaₓO_{y}, ou un oxyde de tungstène WOx. La couche d'oxyde 20 peut également être à base ou comporter de l'oxyde de silicium. Éventuellement, la couche de matériau diélectrique 20 peut comporter plusieurs sous-couches d'oxydes superposées.

Lorsqu'elle est en oxyde d'hafnium, la couche 20 de matériau diélectrique peut être prévue avec une épaisseur comprise par exemple entre 3nm et 20nm, et de préférence entre 5nm et 10nm.

Plutôt que d'établir une zone de commutation au centre d'une région dopée de la couche diélectrique dans laquelle on a créé des charges, les inventeurs ont découvert, de manière surprenante, qu'un confinement spatial du filament conducteur pouvait être obtenu au niveau d'une zone d'interface 23 entre des régions 21, 22 diélectriques accolées de compositions différentes, en particulier en termes de dopage et/ou de constante diélectrique.

La cellule C₁ a donc ici la particularité d'avoir une zone de commutation, autrement dit une zone de formation de filament conducteur, qui se situe à une interface 23 entre deux régions 21, 22 diélectrique distinctes et en contact l'une de l'autre. Ces régions 21, 22 distinctes de la couche de matériau diélectrique 20 peuvent être des régions d'un même matériau diélectrique mais avec des dopages respectifs différents ou bien constituées de matériaux diélectriques différents avec des constantes diélectriques respectives différentes.

Ainsi, selon une possibilité de mise en œuvre, une première région 21 de la couche diélectrique 20 comporte un élément dopant, typiquement du silicium ou de l'aluminium, selon une concentration atomique en élément dopant ou une densité d'élément dopant donnée, tandis qu'une deuxième région 22 de la couche diélectrique 20 est non-dopée ou bien est également dopée mais avec une concentration atomique dudit élément dopant plus faible que dans la première région 21.

Lorsque la première région 21 est une région en oxyde, en particulier en oxyde de métal de transition dopée au silicium, on peut prévoir une concentration atomique en élément dopant comprise entre 0.1% et 5%, avantageusement entre 0.3% et 2%, et de préférence entre 0.5% et 1.5%.

Dans le cas où la première région 21 et la deuxième région 22 sont toutes les deux dopées au silicium, on peut prévoir un écart de concentration de préférence supérieur à 0.3%.

Lorsque la première région 21 est une région en oxyde dopée à l'aluminium, on peut prévoir une concentration atomique en élément dopant de préférence supérieure à 1%, par exemple entre 1% et 5%. Dans le cas où la première région 21 et la deuxième région 22 sont toutes les deux dopées à l'aluminium on peut prévoir un écart de concentration de préférence supérieur à 0.3%.

Ainsi, un exemple particulier de composition de la couche diélectrique 20 prévoit une première région 21 à base d'oxyde d'hafnium dopée au silicium (HfO₂:Si) ou à l'aluminium, tandis que la deuxième région 22 est en oxyde d'hafnium non-dopé ou avec une concentration en dopants, en particulier en silicium ou en aluminium, inférieure à celle de la première région 21.

Selon un autre exemple, la première région 21 peut être à base d'oxyde de tantale (Ta₂O₅:Si, TaOₓ:Si) dopé au silicium tandis que la deuxième région 22 est en oxyde de tantale non dopé ou avec une concentration en silicium inférieure à celle de la première région 21.

Un troisième exemple de composition prévoit une première région 21 en oxyde de silicium dopé à l'hafnium tandis que la deuxième région 22 est en oxyde de silicium non-dopé ou dopé par exemple à l'hafnium et comportant une concentration en hafnium inférieure à celle de la première région 21.

En variante, les régions 21, 22 peuvent être des régions d'un même oxyde de métal de transition, mais dopées avec des espèces différentes. Dans ce cas, un exemple particulier de réalisation prévoit une première région 21 à base d'oxyde d'hafnium dopée au silicium, tandis que la deuxième région 22 est en oxyde d'hafnium dopée à l'aluminium.

Selon une autre variante, les régions 21, 22 peuvent être des régions à base de matériaux diélectriques différents et ayant des constantes diélectriques différentes. Un exemple de réalisation particulier de cette variante prévoit la deuxième région 22 en un matériau diélectrique de type communément appelé « high-k », autrement dit avec une constante diélectrique supérieure à celle de l'oxyde de silicium, en particulier un oxyde de métal de transition par exemple de l'oxyde d'hafnium, et la première région 21 à base d'un autre matériau diélectrique, par exemple du SiO₂ ou du nitrure de silicium (SiₓN_{y}), un matériau diélectrique de type communément appelé « low-k » (constante diélectrique inférieure à celle de l'oxyde de silicium).

Pour disposer la zone de commutation à l'interface 23 entre les régions 21, 22 de la couche diélectrique 20, les électrodes 10, 30 sont agencées en regard de cette interface 23. L'interface 23 s'étend dans un plan Pₘ traversant la couche diélectrique 20 et passant par les électrodes 10, 30.

Dans l'exemple de réalisation particulier illustré, le plan Pₘ dans lequel l'interface 23 s'étend peut former un plan médian de l'électrode supérieure 10 et/ou inférieure 30. Par « plan médian », on entend ici un plan vertical divisant en deux parties sensiblement égales l'électrode inférieure et/ou supérieure. Par « plan vertical », on entend un plan qui s'étend parallèlement à l'axe z du repère orthogonal [O; x; y; z] donné sur la figure 1.

L'agencement des régions 21, 22 en regard des électrodes peut être tel que la première région 21 diélectrique s'étend dans une direction parallèle à un plan principal de la couche diélectrique 20, depuis ladite interface 23 au moins jusqu'à une zone 21A située en regard d'une première face latérale 30A délimitant au moins une des électrodes 20, 30 ici de l'électrode supérieure 30. La deuxième région diélectrique 22 s'étend, quant à elle, dans une direction parallèle à un plan principal de la couche diélectrique 20 entre ladite interface 23 et une zone 22B dans le prolongement d'une deuxième face latérale 30B délimitant ladite électrode supérieure 30 et qui est opposée à ladite première face latérale 30A. Par « plan principal » de la couche diélectrique 20, on entend un plan passant par cette couche diélectrique 20 et qui s'étend le long de cette couche diélectrique 20 parallèlement au plan [O ; x; y] du repère orthogonal [O ; x ; y ; z] donné sur la figure 1.

L'agencement des régions 21, 22 diélectriques peut être avantageusement prévu comme dans l'exemple illustré sur la figure 1 avec une unique interface 23 entre régions 21, 22 de compositions différentes, la cellule C₁ comportant alors une unique zone de commutation en regard de l'électrode supérieure 30. Cela peut permettre de réduire la consommation électrique et le niveau des tensions de lecture, écriture, effacement appliquées par rapport à une cellule dans laquelle on aurait plusieurs zones de commutation en regard d'une même électrode 30.

Avantageusement, au moins une des électrodes est centrée en regard de la zone d'interface 23, ce qui permet de favoriser davantage le confinement du filament conducteur au niveau de l'interface 23 entre les régions 21, 22. Ainsi, au moins une des électrodes, dans cet exemple l'électrode supérieure 30, s'étend en regard d'une surface 21s de la première région 21 égal ou sensiblement égal à une surface 22s de la deuxième région 22 en regard de laquelle elle s'étend.

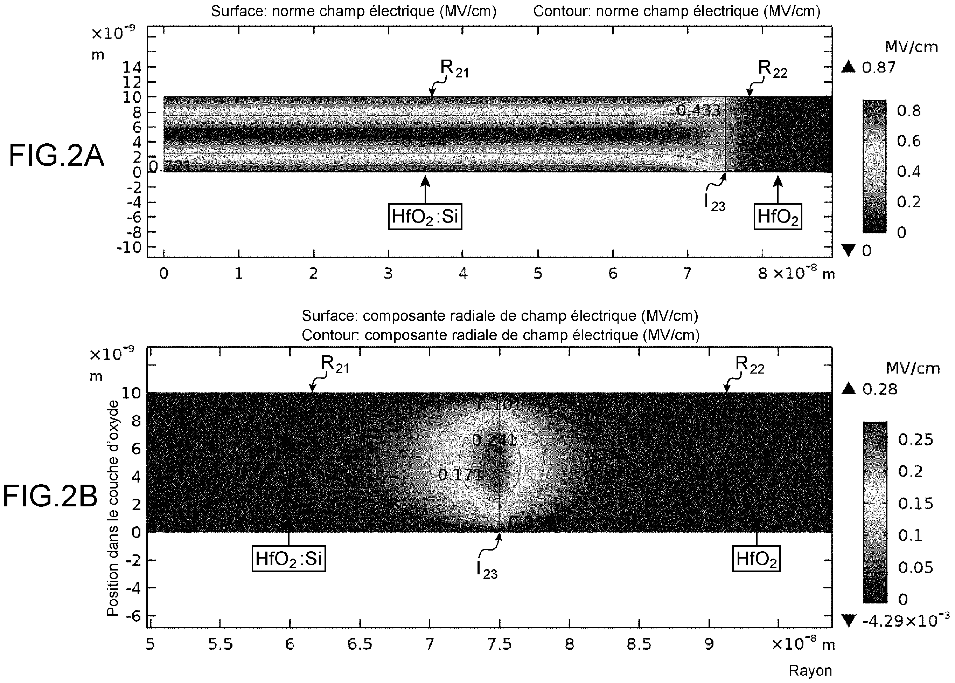

Les figures 2A-2B donnent des résultats de simulations obtenus à l'aide de l'outil COMSOL Multiphysics respectivement sur une composante axiale et une composante radiale de champ électrique dans la couche diélectrique d'une structure de cellule du type de celle décrite précédemment.

Les électrodes sont en particulier agencées en regard d'une interface entre une première région R₂₁ en oxyde d'hafnium dopée au silicium et une deuxième région R₂₂ en oxyde d'hafnium non-dopé. La composante radiale du champ électrique plus importante au niveau de l'interface I₂₃ entre région non chargée et qui n'est pas dopée au silicium et la région chargée montre qu'une densité de courant plus importante est obtenue au niveau de cette interface I₂₃ et, par conséquent, un effet de confinement du filament conducteur est obtenu.

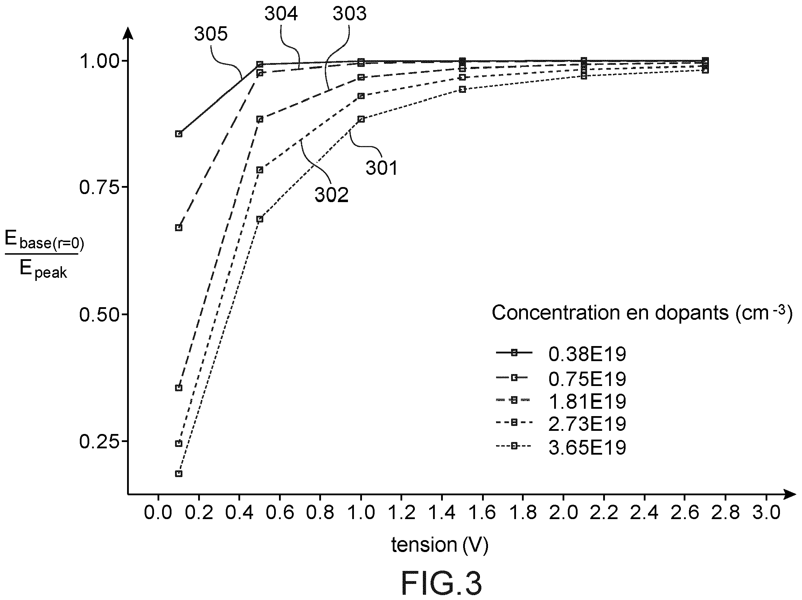

Sur la figure 3, différentes courbes 301, 302, 303, 304, 305 représentatives du rapport de champ électrique radial de référence au niveau de l'interface et de champ électrique radial lorsqu'on s'éloigne de cette interface en fonction de la tension de formation ('forming') appliquée aux électrodes, respectivement pour différentes concentrations en dopants (respectivement 3.65E19 cm⁻³, 2.73E19 cm⁻³, 1.81E19 cm⁻³, 0.75E19 cm⁻³ 0.38E19 cm⁻³) de la première région d'une structure de cellule telle que décrite précédemment, cette première région étant en matériau diélectrique de constante diélectrique k₁ = 19.2, tandis que la deuxième région est non-dopée avec une constante diélectrique k₂ = 20. On observe ici qu'une cellule agencée suivant l'invention permet de fonctionner à des niveaux de tensions de formation ('forming') entre 0.5 Volts et 1.5 Volts, autrement dit à des niveaux de tensions inférieurs à ceux des dispositifs suivant l'art antérieur.

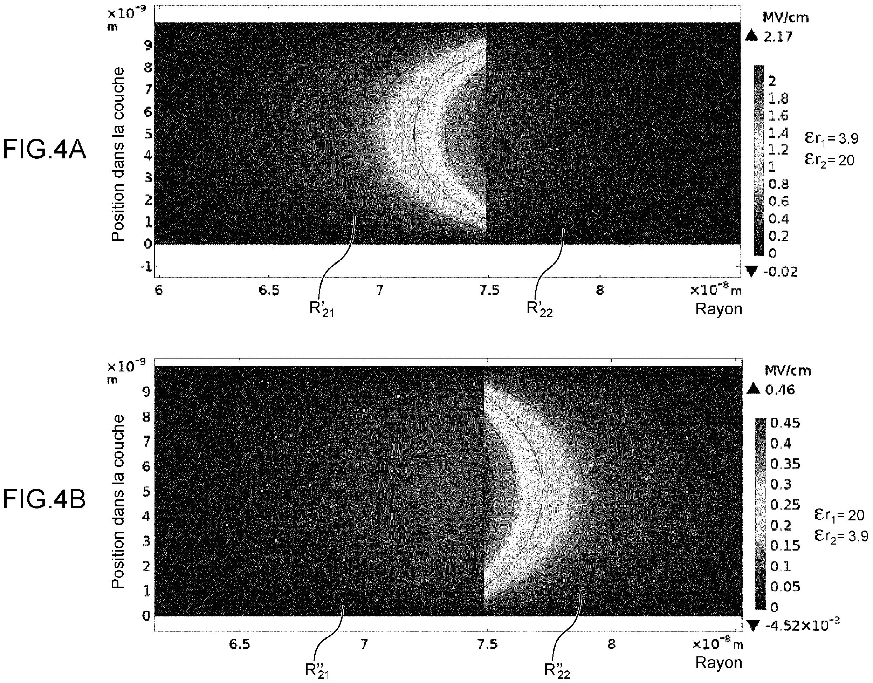

D'autres résultats de simulation de composante radiale de champ électrique sont donnés sur les figures 4A et 4B respectivement pour une première cellule ayant une interface entre une première région R'₂₁ de constante diélectrique k'₁ = 3.9 et une deuxième région R'₂₂ de constante diélectrique k'₂ = 20, et pour une deuxième cellule avec une interface entre une première région R"₂₁ ayant une constante diélectrique k"₁= 20 et une deuxième région R"₂₂ de constante diélectrique k"₂ = 3.9. On constate ainsi que l'extension spatiale du champ électrique radial dépend de l'écart de constante diélectrique entre les régions en contact l'une de l'autre et formant l'interface où la zone de commutation est située.

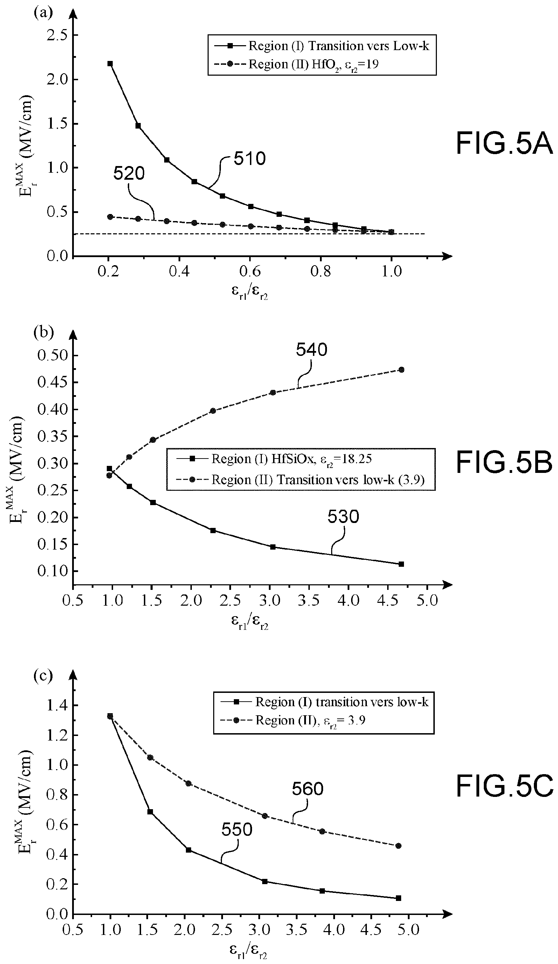

Les figures 5A, 5B, 5C donnent chacune des courbes de résultats de simulation donnant l'évolution d'un champ électrique radial maximal dans une structure de cellule telle que décrite précédemment en fonction du rapport de constante diélectrique entre la première région diélectrique, qui est ici dopée, et la deuxième région qui n'est pas dopée.

Sur la figure 5A, la première région (courbe 510) a une constante diélectrique qui varie pour se rapprocher du comportement d'un diélectrique low-k, tandis que la deuxième région (courbe 520) accolée à la première région est en oxyde d'hafnium non dopé de constante diélectrique égale à 19.

Sur la figure 5B, la première région (courbe 530) est en oxyde d'hafnium dopé au silicium avec une constante diélectrique de l'ordre de 18.25, tandis que la deuxième région (courbe 530) a une constante diélectrique qui varie pour se rapprocher du comportement d'un diélectrique low-k.

Sur la figure 5C, la première région 550 a une constante diélectrique qui varie pour se rapprocher du comportement d'un diélectrique low-k, tandis qu'une deuxième région 560 accolée à la première région est prévue avec une constante diélectrique de 3.9.

On constate ainsi, que dès lors qu'une différence de constante diélectrique existe entre la première et la deuxième région, on obtient une exacerbation du champ électrique radial et que ce phénomène est d'autant plus important que le rapport de constante diélectrique entre les deux régions augmente.

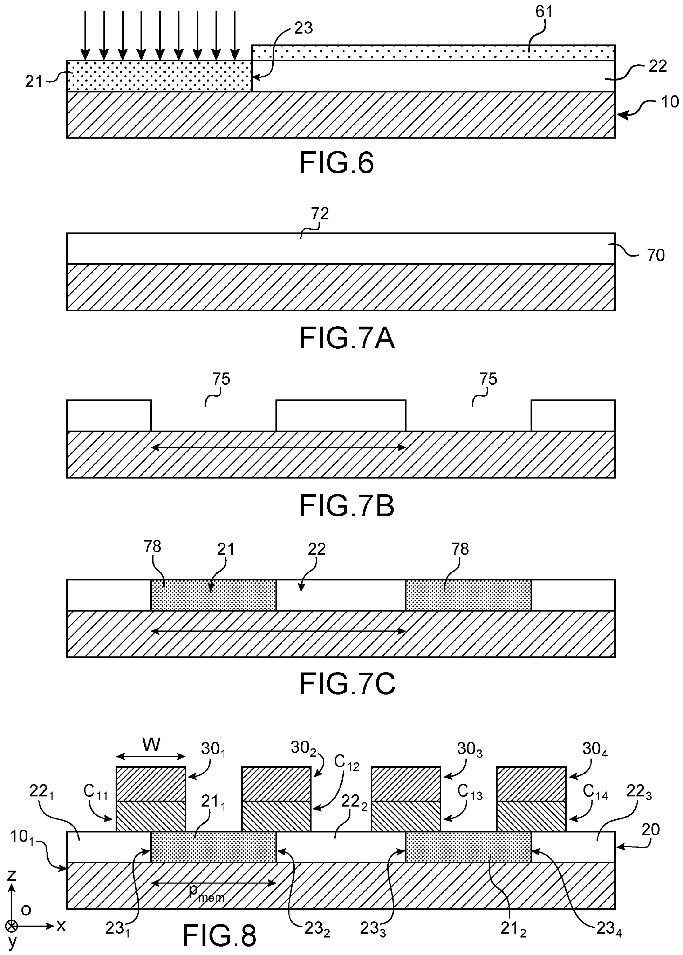

Une manière particulière de fabriquer une interface 23 de cellule mémoire telle que décrite précédemment formée de régions 21, 22 juxtaposées et en contact l'une de l'autre est illustrée sur la figure 6.

A partir d'une structure comportant la couche de matériau diélectrique 20 agencée sur l'électrode inférieure 10, la première région 21 est dopée à l'aide d'une implantation ou de plusieurs implantations successives. On effectue la ou les implantations dans une couche diélectrique 20, tandis qu'une deuxième région 22 de cette couche 20 est préservée lors de cette implantation, typiquement par le biais d'un masque 61 agencé sur la deuxième région 22.

Par exemple, pour doper une couche 20 d'oxyde d'hafnium de l'ordre de 10nm d'épaisseur à une concentration atomique en silicium comprise entre 1% et 5%, une implantation effectuée à une énergie de 4keV, avec une dose comprise entre 1^{∗}10¹⁵ atomes^{∗}cm-2 et 5^{∗}10¹⁵ atomes^{∗}cm-2 peut être effectuée. Puis, on retire le masque 61.

On peut avantageusement réaliser les régions 21, 22 juxtaposées et donc l'interface 23 entre ces régions 21, 22 destinée à former la zone de commutation, sans réaliser de recuit de diffusion de dopants après l'implantation.

L'électrode supérieure est ensuite réalisée en regard de l'interface 23 entre région implantée et région non implantée, et éventuellement centrée en regard de cette interface 23.

Un exemple de réalisation d'une structure ayant une interface 23 telle que décrite précédemment avec cette fois des matériaux diélectriques différents est illustré sur les figures 7A-7C.

Après le dépôt (figure 7A) d'une couche 70 d'un premier matériau diélectrique 72, par exemple en nitrure de silicium, on forme une ou plusieurs ouvertures 75 dans cette couche 70 en dévoilant l'électrode inférieure 10 (figure 7B).

Les ouvertures 75 peuvent être réalisées à l'aide d'un procédé de photolithographie lors duquel on forme un masquage (non représenté) et au travers duquel on effectue une gravure de la couche diélectrique 70.

Puis, la ou les ouvertures 75 sont remplies au moyen d'un autre matériau diélectrique 78, par exemple de l'oxyde d'hafnium. On peut ensuite réaliser une planarisation CMP (pour « Chemical Mechanical Planarization ») afin d'obtenir une couche plane comportant au moins une région 21 en un matériau diélectrique accolée à une autre région en matériau diélectrique 22 de constante diélectrique différente de celle du premier matériau.

Un agencement du dispositif de mémoire résistive avec cette fois plusieurs cellules mémoires C₁₁, C₁₂, C₁₃, C₁₄ est donné sur la figure 8.

La matrice mémoire est ici pourvue d'électrodes supérieures 30₁, 30₂, 30₃, 30₄ distinctes et qui peuvent ne pas être connectées entre elles. Ces électrodes supérieures 30₁, 30₂, 30₃, 30₄ sont agencées en regard respectivement d'interfaces 23₁, 23₂, 23₃, 23₄ entre des régions diélectriques accolées ayant des constantes diélectriques respectives différentes et/ou des concentrations en élément dopant différentes. Les zones de commutation respectives des cellules C₁₁, C₁₂, C₁₃, C₁₄ sont ainsi également placées au niveau des interfaces 23₁, 23₂, 23₃, 23₄.

La couche diélectrique 20 comporte cette fois une alternance de régions 21₁, 21₂, d'un premier type ayant une composition qui peut être semblable à celle de la première région 21 de la structure décrite précédemment en lien avec la figure 1, et de régions 22₁, 22₂, 22₃, d'un deuxième type, de composition et constante diélectrique différentes de la première région. Les régions 22₁, 22₂, 22₃ peuvent avoir une composition semblable à celle de la deuxième région 22 décrite précédemment en lien avec la figure 1.

Ainsi, les régions 22₁, 22₂, 22₃ sont par exemple des régions non-dopées d'une couche en oxyde d'hafnium, tandis que les régions 21₁, 21₂ sont par exemple des régions implantées avec du silicium dans cette couche d'oxyde d'hafnium.

Une électrode 30₁ supérieure et une autre électrode supérieure 30₂ sont ici disposées partiellement en regard d'une même région diélectrique 21₁ du premier type, par exemple d'oxyde de métal de transition dopé, et partiellement en regard de deux régions diélectriques 22₁, 22₁ du second type, tout en étant placées en regard d'interfaces 23₁, 23₂ distinctes. Les électrodes 30₁, 30₂ peuvent donc permettre d'alimenter des zones de commutation distinctes.

De même, une autre électrode 30₃ supérieure et l'électrode supérieure 30₂ sont placées en partie chevauchantes sur une même région diélectrique 22₂, par exemple d'oxyde de métal de transition non-dopé, tout en étant disposées en regard d'interfaces 23₂, 23₃ distinctes et de zones de commutation distinctes.

De tels agencements permettent notamment de pouvoir réaliser des mémoires de faibles dimensions tout en ayant des contraintes réduites concernant leur dimensionnement, notamment en ce qui concerne le pas pₘₑₘ de répartition des cellules C₁₁, C₁₂, C₁₃, C₁₄ mémoires ainsi que la largeur W des électrodes. À dimension de cellule égale, on peut obtenir un pas deux fois plus important tout en ayant une largeur W d'électrode accrue par rapport à un dispositif suivant l'art antérieur.

À dimension de cellule égale, le fait de prévoir des électrodes de largeur W plus importante peut permettre de relâcher les contraintes de tolérance au désalignement entre un niveau donné du dispositif microélectronique dans lequel les cellules mémoires C₁₁, C₁₂, C₁₃, C₁₄ sont formées et un niveau supérieur et/ou inférieur au niveau donné. Cela peut également permettre de faciliter la prise de contact sur les électrodes et rendre la conception des cellules plus aisée en termes de contrainte d'agencement.

Comme dans l'exemple de réalisation décrit précédemment, les électrodes supérieures 30₁, 30₂, 30₃, 30₄, peuvent être centrées en regard respectivement des zones 23₁, 23₂, 23₃, 23₄. On peut également prévoir une seule zone de commutation par cellule, de sorte que deux électrodes supérieures 30₁, 30₂, distinctes permettent de commander deux zones de commutation distinctes de deux cellules distinctes.

Dans l'exemple de réalisation particulier illustré sur la figure 8, une seule électrode 10₁ inférieure est représentée mais le dispositif peut être également muni d'électrodes inférieures supplémentaires (non représentées) typiquement parallèles entre elles. Les électrodes inférieures et supérieures ont ici des orientations respectives différentes. Ainsi, dans l'exemple de réalisation particulier illustré sur la figure 8, la mémoire suit un agencement de type dit « crossbar ».

Les électrodes supérieures 30₁, 30₂, 30₃, 30₄ s'étendent ainsi parallèlement à une direction donnée, dans cet exemple parallèle à l'axe y du repère [O ; x; y; z], tandis que la ou les électrodes inférieures 10₁ s'étendent parallèlement à une autre direction, orthogonale à ladite direction donnée et dans cet exemple parallèle à l'axe x.

Dans l'exemple de réalisation illustré, ce sont les électrodes supérieures 30₁, 30₂, 30₃, 30₄ dont l'orientation suit celle des zones d'interfaces 23₁, 23₂, 23₃, 23₄, mais il est également possible de prévoir un agencement inverse où les électrodes inférieures 10₁, 10₂, 10₃, 10₄ sont orientées dans une direction parallèle à celle dans laquelle les zones d'interfaces 23₁, 23₂, 23₃, 23₄, les électrodes supérieures étant alors orthogonales aux électrodes inférieures.

D'autres types d'agencements d'électrodes qu'un agencement de type « crossbar » peuvent être envisagés.

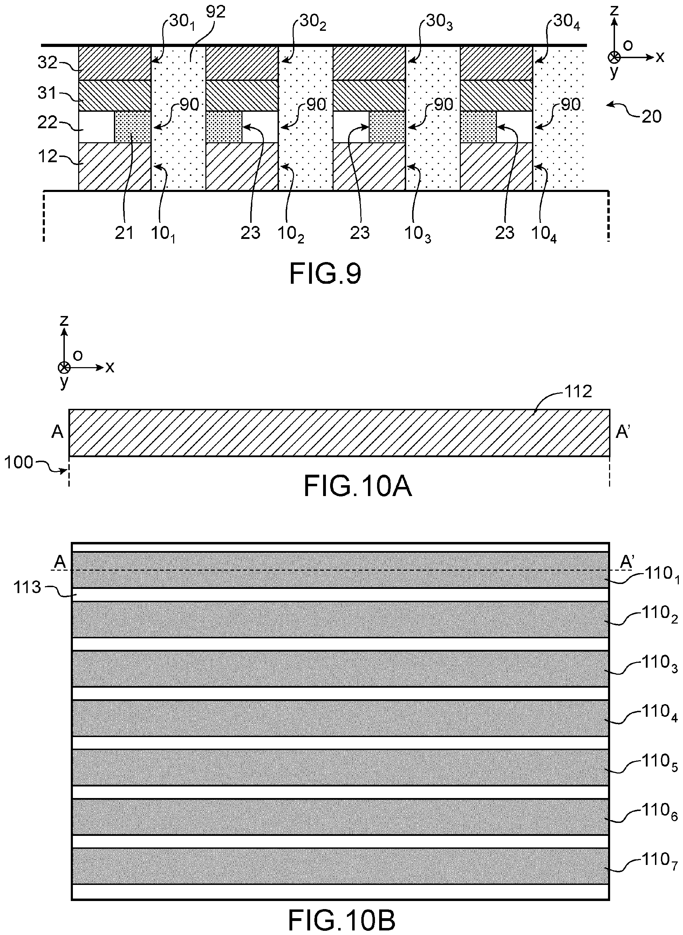

Ainsi, dans l'exemple de réalisation illustré sur la figure 9, les électrodes supérieures 30₁, 30₂, 30₃, 30₄, et les électrodes inférieures 10₁, 10₂, 10₃, 10₄, des cellules mémoires résistives suivent cette fois une même orientation. Chaque paire d'électrodes supérieure et inférieure est répartie ici de manière symétrique de part et d'autre d'un bloc 90 de matériau diélectrique comportant une interface 23 entre une région diélectrique 21 et une région diélectrique 22 accolée de constante diélectrique différente et/ou de dopage différent. Les paires d'électrodes 10₁, 30₁, 10₂, 30₂,..., sont ici séparées entre elles par des tranchées remplies de matériau isolant 92, par exemple du nitrure de silicium SiN ou du SiO₂.

Pour réaliser un dispositif mémoire tel que décrit précédemment, on peut partir d'un support formé d'un substrat, de type massif (bulk) ou de type semi-conducteur sur isolant par exemple SOI sur lequel au moins un étage de transistors est réalisé.

Un exemple particulier de réalisation illustré sur les figures 10A-10F, prévoit de fabriquer le dispositif mémoire lors d'un ensemble d'étapes de back-end au-dessus du niveau des transistors et d'au moins un étage d'éléments de connexion déjà formés.

On réalise tout d'abord (figures 10A et 10B donnant une vue de dessus du dispositif) une pluralité de lignes conductrices parallèles 110₁,... 110₇ en déposant sur cet étage (représenté de manière schématique par un bloc 100 en trait discontinu sur la figure 10A) un matériau conducteur 112 par exemple à base de TiN d'épaisseur qui peut être comprise par exemple entre 10nm et 300nm.

Les lignes conductrices parallèles 110₁,... 110₇ peuvent être formées par gravure ou bien par remplissage de tranchées. Des zones isolantes 113, par exemple en oxyde de silicium, sont prévues entre les lignes conductrices.

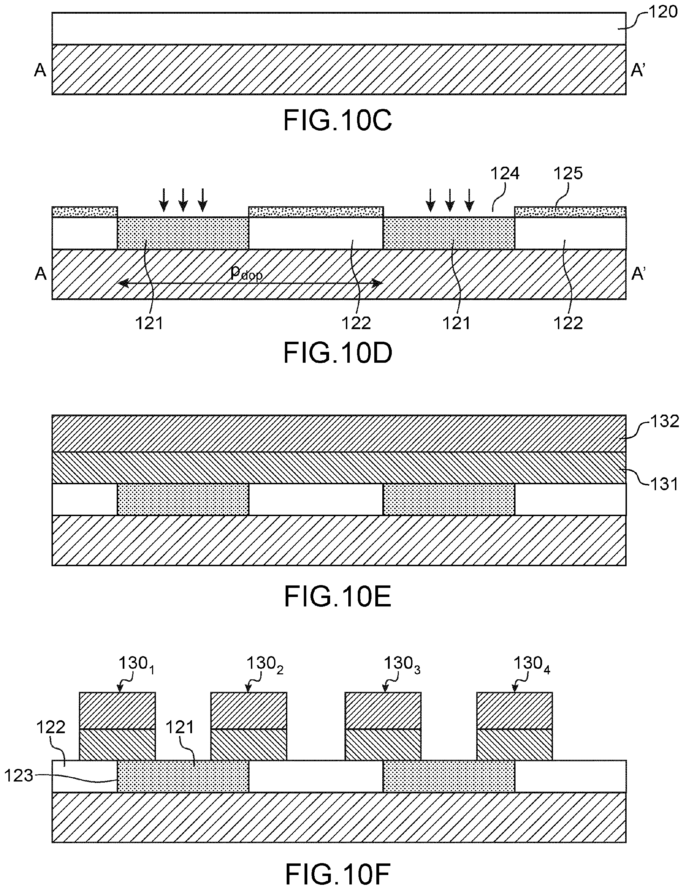

Ensuite (figure 10C), on dépose au moins une couche 120 de matériau diélectrique tel que par exemple de l'oxyde d'hafnium ou de l'oxyde de tantale selon une épaisseur qui peut être comprise par exemple entre 3nm et 25nm.

Puis (figure 10D), on réalise dans cette couche 120 d'oxyde, des régions dopées 121 en effectuant une ou plusieurs implantations successives. Dans le cas où la couche de matériau diélectrique 120 est une couche d'oxyde de métal de transition tel que de l'oxyde d'hafnium ou de l'oxyde de tantale, une implantation de silicium ou d'aluminium peut être réalisée. Typiquement, l'implantation est effectuée au travers d'ouvertures 124 d'un masque 125, qui est ensuite retiré. Les ouvertures 124 du masque 125 peuvent être sous forme de tranchées oblongues, par exemple rectangulaire de manière à réaliser des régions dopées 121 de forme correspondante.

Les régions dopées 121 peuvent être réparties de manière régulière selon un pas p_{dop} deux fois plus élevé que celui des points mémoire. Le pas de répartition des points mémoire peut correspondre à celui des interfaces entre régions dopées 121 et régions 122 non-dopées.

Ensuite (figure 10E), on réalise un empilement conducteur doté d'une couche 131 en matériau capteur d'oxygène, par exemple à base de Ti, et d'épaisseur qui peut être comprise par exemple entre 3nm et 20nm. L'empilement comporte également une couche 132 de matériau conducteur, par exemple en TiN, déposée sur le matériau capteur d'oxygène et d'épaisseur qui peut être comprise par exemple entre 5nm. 300nm.

Puis (figure 10F), on forme des motifs par photolithographie dans l'empilement conducteur, de sorte à réaliser les électrodes supérieures 130₁, 130₂, 130₃, 130₄, en regard d'interfaces 123₁, 123₂, 123₃, 123₄ entre régions 121 d'oxyde dopé et régions 122 d'oxyde non-dopé.

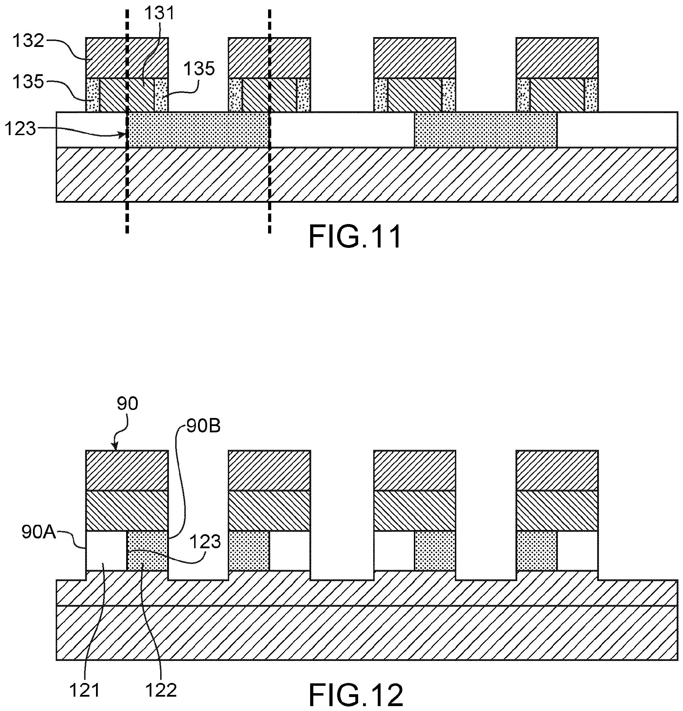

La gravure des couches 131, 132 pour former l'électrode supérieure 130, en particulier de la couche de matériau capteur d'oxygène, typiquement à base de Ti, peut, comme cela est illustré sur la figure 11, conduire à une formation de zones oxydées 135 au niveau des flancs latéraux des électrodes 130₁, 130₂, 130₃, 130₄. Dans ce cas, par rapport à des cellules suivant l'art antérieur, l'impact de telles zones oxydées 135 sur le fonctionnement des cellules est moindre dans la mesure où la zone de commutation est ici prévue au niveau de l'interface 123, autrement dit à distance des zones oxydées 135.

Selon une variante de réalisation illustrée sur la figure 12, une gravure anisotrope est effectuée pour réaliser les électrodes supérieures 130 que l'on poursuit ensuite dans la couche de matériau diélectrique 120 et dans la ou les couches formant la ou les électrodes inférieures.

Les régions 121 et 122 formant l'interface 123 où se situe la zone de commutation, s'arrêtent dans ce cas dans le prolongement de flancs latéraux des électrodes supérieures. Un tel agencement avec une couche diélectrique gravée en blocs 90 distincts chacun doté d'une interface 123 ne vient, là encore, pas perturber le fonctionnement de la zone de commutation dans la mesure où celle-ci se trouve à distance de flancs latéraux 90A, 90B des blocs 90.

Selon une autre variante de réalisation du procédé décrit précédemment, les régions dopées 121 peuvent être réalisées en plusieurs étapes par des implantations successives, respectivement à travers des ouvertures d'un masquage qui sont orientées dans une première direction, puis à travers d'autres ouvertures d'un autre masquage qui sont orientées dans une deuxième direction orthogonale à la première direction.

## Revendications

1. Structure de mémoire (C₁, C₁₁) résistive comprenant au moins une cellule mémoire dotée d'une première électrode (10, 10₁) et d'une deuxième électrode (30, 30₁) agencées de part et d'autre d'une couche (20) diélectrique, la cellule mémoire étant apte à commuter de manière réversible entre un état dit « de forte résistance » et un état dit « de faible résistance », ladite couche diélectrique (20) comportant une zone de commutation formant un chemin de conduction privilégié au courant lorsque ladite cellule mémoire se trouve dans ledit état de faible résistance,
ladite couche diélectrique (20) comportant une première région (21, 21₁) et une deuxième région (22, 22₁) accolées l'une à l'autre de manière à former une interface (23) entre lesdites première et deuxième régions (21, 21₁;22, 22₁), lesdites première et deuxième région (22, 22₁) étant en un même matériau diélectrique et ayant des compositions différentes en élément(s) dopant(s) ou en concentration d'élément dopant ou étant respectivement en un premier matériau diélectrique et un deuxième matériau diélectrique de constantes diélectriques respectives différentes,
la première électrode et la deuxième électrode étant agencées en regard de ladite interface (23, 23₁) entre ladite première région (21, 21₁) et ladite deuxième région (22, 22₁), ladite interface (23, 23₁) s'étendant dans un plan donné (Pₘ) traversant la couche diélectrique (20) et passant par les électrodes (10, 30) de sorte à localiser ladite zone de commutation au niveau de ladite zone d'interface (23, 23₁).

2. Structure selon la revendication 1, dans laquelle une électrode donnée (30, 30₁) parmi lesdites première électrode (30, 30₁) et deuxième électrode (10, 10₁) est centrée en regard de ladite interface (23, 23₁) et s'étend en regard d'une surface (21s) de la première région (21) égale ou sensiblement égale à une surface (22s) de la deuxième région (22) en regard de laquelle cette électrode donnée (30, 30₁) s'étend.

3. Structure selon l'une des revendications 1 ou 2, dans laquelle ladite première région (21, 21₁) s'étend, dans une direction (x) parallèle à un plan principal de ladite couche diélectrique (20), entre ladite interface (23, 23₁) et une zone (21A) située en regard d'une première face latérale (30B) d'au moins une électrode donnée (30, 30₁) parmi lesdites première électrode et deuxième électrode, ladite deuxième région (22, 22₁) s'étendant, dans une direction parallèle à un plan principal de la couche diélectrique (20), entre ladite interface (23) et une autre zone (22A) en regard d'une deuxième face latérale (30A) de ladite électrode donnée (30, 30₁) opposée à ladite première face latérale (30B).

4. Structure selon l'une des revendications 1 à 3, dans laquelle la couche diélectrique (20) comporte une alternance de régions (21₁, 21₂) d'un premier type ayant une composition identique à ladite première région et de régions (22₁, 22₂, 22₃) d'un deuxième type et de même composition que la deuxième région, au moins une électrode donnée (30, 30₁) parmi lesdites première électrode (30, 30₁) et deuxième électrode (10, 10₁) étant en regard d'une unique interface (23) entre région du premier type et région du deuxième type.

5. Structure selon l'une des revendications 1 à 4, dans lequel ladite couche d'oxyde est à base de l'un des oxydes suivants : oxyde d'hafnium (HfO₂, HfOₓ), oxyde de tantale (Ta₂O₅, TaₓO_{y}), oxyde de tungstène (WOₓ), oxyde de silicium (SiO₂, SiOₓ).

6. Structure de mémoire résistive selon l'une des revendications 1 à 5, comprenant en outre :
- une troisième électrode (30₂) juxtaposée à, et distincte de, ladite deuxième électrode (30₁), la troisième électrode (30₂) étant agencée en regard d'une autre interface (23₂) entre ladite première région (21₁) et une troisième région (22₂) de ladite couche diélectrique (20),
ladite troisième région (22₂) étant juxtaposée à ladite première région (21₁) et disposée de sorte que ladite première région (21₁) se situe entre ladite troisième région (22₂) et ladite deuxième région (22₁), ladite première région (21₁) et ladite troisième région (22₂) étant en un même matériau diélectrique et ayant des compositions différentes en élément(s) dopant(s) ou en concentration d'élément dopant ou étant respectivement en un premier matériau diélectrique et un deuxième matériau diélectrique de constantes diélectriques respectives différentes.

7. Structure de mémoire résistive selon la revendication 6, ladite deuxième région (22₁) et ladite troisième région (22₂) étant en un même matériau diélectrique.

8. Structure de mémoire résistive selon l'une des revendications 6 ou 7, comprenant en outre une quatrième électrode (30₃) juxtaposée à ladite deuxième électrode (30₂) et distincte de la troisième électrode (30₂), ladite quatrième électrode (30₃) étant agencée en regard d'une autre zone d'interface (23₃) entre ladite troisième région (22₂) et une quatrième région (21₂) de ladite couche diélectrique (20), ladite quatrième région (21₂) étant juxtaposée à ladite troisième région (22₂), et disposée de sorte que ladite troisième région (22₂) se situe entre ladite quatrième région (21₂) et ladite deuxième région (21₁), ladite quatrième région (21₂) étant à base du même matériau que la première région (21₁).

9. Structure de mémoire résistive selon l'une des revendications 1 à 8, dans lequel la couche diélectrique (20) est une couche d'oxyde, en particulier d'oxyde de métal de transition, ladite première région (21, 21₁) étant une région dopée de ladite couche d'oxyde à l'aide d'un premier élément dopant, en particulier du silicium ou de l'aluminium, présent selon une première concentration atomique,
- la deuxième région (22, 22₁) étant une région non-dopée dudit oxyde ou,
- ladite deuxième région (22, 22₁) étant une région dopée dudit oxyde et comportant une deuxième concentration atomique dudit premier élément dopant distincte de ladite première concentration ou,
- ladite deuxième région (22, 22₁) étant dopée au moyen d'un deuxième élément dopant, tel que l'aluminium ou le silicium, qui est distinct dudit premier élément dopant.

10. Structure selon la revendication 9, dans lequel ladite première région (21, 21₁) est en oxyde d'hafnium dopée au silicium ou dopée à l'aluminium, ladite deuxième région (22, 22₁) étant :
- en oxyde d'hafnium non dopé ou,
- en oxyde d'hafnium dopé au silicium avec une concentration en silicium inférieure à la concentration en silicium de ladite première région,
- en oxyde d'hafnium dopé au silicium lorsque la première région est en oxyde d'hafnium dopé à l'aluminium.

11. Structure de mémoire résistive selon l'une des revendications 1 à 10, dans lequel la première électrode (10₁) s'étend dans une direction parallèle à une première direction, la deuxième électrode (30₁) et la troisième électrode (30₂) s'étendant dans une direction parallèle à la deuxième direction, ladite deuxième direction étant orthogonale à ladite première direction.

12. Procédé de réalisation d'une structure de mémoire selon l'une des revendications 1 à 11, dans lequel ladite couche diélectrique (20) est une couche d'oxyde de métal de transition, ledit procédé comprenant des étapes de :
- implantation, à l'aide de silicium ou d'aluminium, de ladite couche de matériau diélectrique, de manière à réaliser ladite première région (21, 21₁) puis,
- formation sur ladite couche de matériau diélectrique de ladite deuxième électrode en regard d'une zone d'interface entre ladite première région et une autre zone non-dopée ou ayant un dopage différent de celui de la première région (21, 21₁).

13. Procédé de réalisation d'une structure de mémoire selon l'une des revendications 1 à 11, dans lequel ladite couche diélectrique (20) est une couche à base d'un premier matériau diélectrique, ledit procédé comprenant des étapes de :
- formation d'une ou plusieurs ouvertures (75) dans ladite couche à base dudit premier matériau diélectrique (72),
- remplissage de la ou les ouvertures (75) à l'aide d'un deuxième matériau diélectrique (78) différent dudit premier matériau diélectrique (72).
